# EUROPEAN PATENT APPLICATION

(11) **EP 1 748 029 A2**
(43) Date of publication of application: **31.01.2007**
(21) Application number: 06011773.6
(22) Date of filing: 07.06.2006
(51) Int. Cl.: B81B 7/00

(54) **Micro-mirror device package and method for fabricating the same**

(30) Priority: 27.07.2005 KR 20050068349
(71) Applicant: Samsung Electronics Co., Ltd., Suwon-si, Gyeonggi-Do (KR)
(72) Inventor: Choi, Won-kyoung, Yeongtong-gu Suwon-si Gyeonggi-do (KR); Kim, Woon-bae, Yeongtong-gu Suwon-si Gyeonggi-do (KR); Mun, Yong-kweun, Giheung-gu Yongin-si Gyeonggi-do (KR); Moon, Chang-youl, Yeongtong-gu Suwon-si Gyeonggi-do (KR); Lee, Sung-hee, Yeongtong-gu Suwon-si Gyeonggi-do (KR)
(74) Representative: Grünecker, Kinkeldey, Stockmair & Schwanhäusser Anwaltssozietät

(57) **Abstract**

A micro-mirror device package including a micro-mirror device; a substrate, on which the micro-mirror device is mounted; and a window lid mounted on the substrate to cover the micro-mirror device. The window lid has a light transmitting part, which is sloped in relation to the micro-mirror device, and through which laser beams are transmitted to the micro-mirror device, and supporting parts downwardly extending from the light transmitting part. When a laser beam is inputted, the package separates the laser beam from noise beams, thereby improving the quality of image on a screen. By fabricating an array of window lids which correspond to micro-mirror devices, respectively, it is possible to fabricate the above-mentioned micro-mirror device package through a batch process performed in terms of a wafer size.

## Description

### BACKGROUND OF THE INVENTION

### Field of the Invention

Methods and apparatuses consistent with the present invention relate to fabrication of a micro-mirror device package, and in particular to a micro-mirror device package and a method for fabricating such a package through a batch process.

### Description of the Related Art

With the arrival of the multimedia age, demand for large displays has increased, and various types of display devices are developed continuously. For example, laser TV's are noticed as the display devices for the next generation because they can implement high resolution although they are large and inexpensive. In general, laser TV's have a micro-scanner for scanning laser beams, which are projected from a laser diode module in horizontal and vertical directions according to RGB image signals. The micro-scanner has a micro-mirror device fabricated through a Micro-Electro Mechanical System (MEMS) technology. The micro-mirror device has a mirror for reflecting light, the direction of which can be changed as the mirror rotates. Such a micro-mirror device is packaged as a single module.

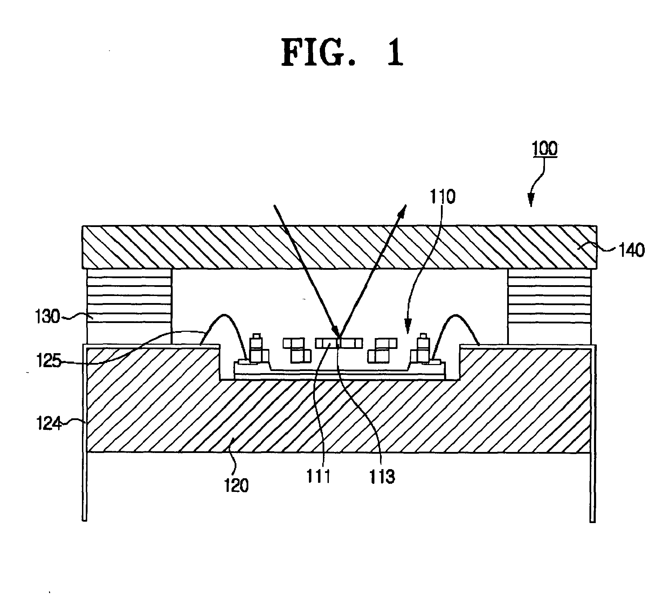

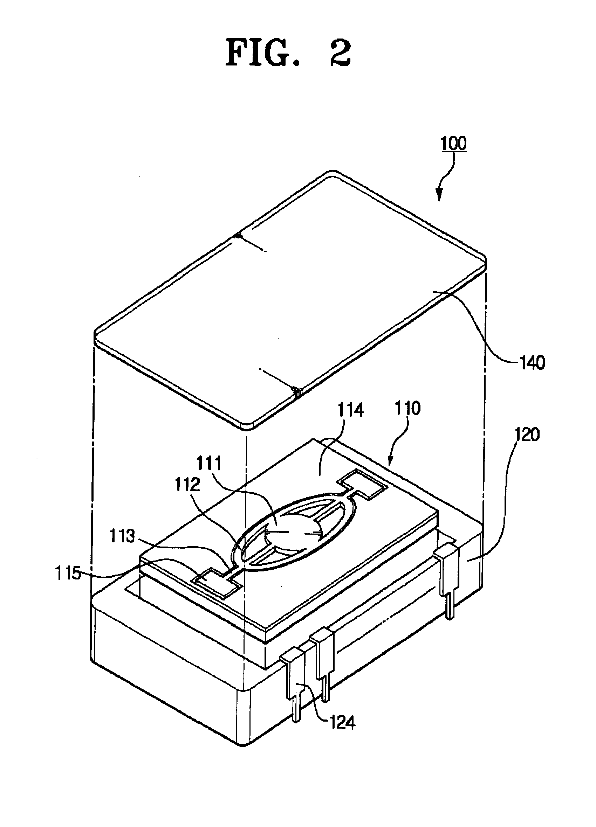

FIGS. 1 and 2 show a conventional micro-mirror device package 100 fabricated by the MEMS technology. Referring to the drawings, the micro-mirror device package has a structure, in which a micro-mirror device 110, a substrate 120 and a window lid 140 are stacked. An insulation structure 130 having electrodes may be formed between the substrate 120 and the window lid 140, and the insulation structure 130 and the substrate 120 may integrally form a housing. The mirror device 110 is conductively connected with a lead frame 124 of the substrate through wires 125 or a pattern.

The drawings exemplify an oval mirror device disclosed in Korean unexamined patent publication No. 10-2005-0053053 filed and copending in the name of the present applicant. The micro-mirror device 110 typically includes a mirror 111 for reflecting light, a pair of springs 113 for supporting the mirror 111, a connection member 112 for interconnecting the mirror 111 and the springs 113, and a frame 114. The frame includes electrodes 115. When image laser beams RGB are incident from the outside, the mirror device reflects the beams as the mirror 111 rotates about X axis, i.e., about the springs 113.

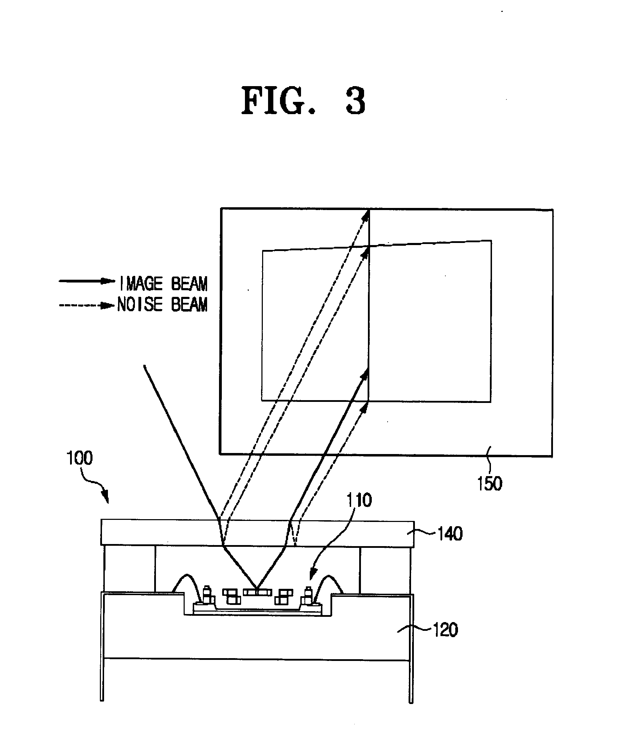

Typically, the micro-mirror device is mounted on the substrate 120 and packaged by covering a transparent window lid 140 so as to protect the mirror 111. Therefore, in a practical micro-mirror device package, when a light signal is inputted, noise beams occur in the same direction as the image signal beam which goes out from the surface of the window lid 140, as shown in FIG. 3; as a result, the quality of image on a screen 150 is poor.

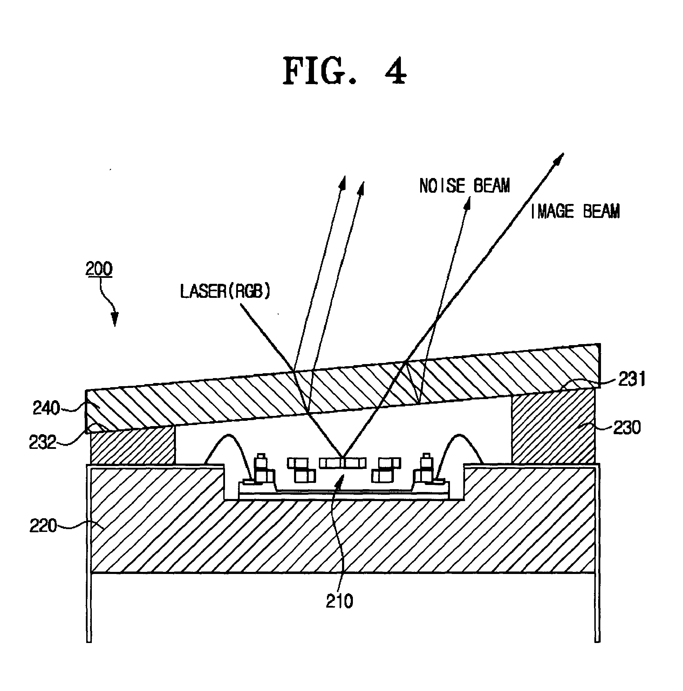

In order to remove such noise beams, various methods have been developed, including anti-refraction coating or geometrical and optical improvement of the window lid or mirror. As one of the results obtained through such methods, FIG. 4 shows a sloped package of another conventional micro-mirror device.

The micro-device package 200 of FIG. 4 is a package developed by the applicant and having a window lid 240 adapted to be sloped and to cover the window of the micro-device 210 when the mirror-device 210 is packaged. With this sloped structure of the micro-device package, the paths of noise beams, which are produced on the surface of the window lid when a laser beam is scanned, are deviated from the path of the laser beam and cannot arrive at the screen; as a result, the quality of image is relatively superior.

However, it is necessary to form the insulation structure 230 in such a way that the parts 231 and 232 of the insulation structure 230, to which the substrate 220 and the lid 240 are bonded, are sloped when the window 240 is bonded to the substrate 220. Otherwise, it is necessary to form the housing for receiving the micro-mirror device 210 in such a way that the housing itself has such a construction. In that event, because the lid 240 has to be bonded to the insulation structure 230 or a housing for each mirror device, glass sealing and wafer level packaging are difficult for the sloped package 200. This means that it is impossible to fabricate such sloped packages in a wafer level-chip size. Accordingly, existing micro-mirror device packages, including sloped packages cannot be further miniaturized due to the constructions thereof and complicated fabricating processes.

### SUMMARY OF THE INVENTION

Accordingly, exemplary embodiments of the present invention have been made to address the above-mentioned issues occurring in the prior art, and an aspect of the present invention is to provide a micro-mirror device package, the window lid of which is improved in construction, so that an image beam scanned by an existing micro-scanner and noise beams can be separated from each other.

Another aspect of the present invention is to provide a method of fabricating, such a micro-mirror device package through a batch process performed in terms of a wafer size.

In order to achieve the above-mentioned aspects, an exemplary embodiment of the present invention provides a micro-mirror device package comprising: a micro-mirror device; a substrate, on which the micro-mirror device is mounted; and a window lid mounted on the substrate to cover the micro-mirror device, wherein the window lid has a light transmitting part, which is sloped in relation to the micro-mirror device, and through which laser beams are transmitted to the micro-mirror device, and supporting parts downwardly extending from the light transmitting part.

The micro-mirror device may be any of well-known micro-mirror devices. However, a micro-mirror device suitable for exemplary embodiments of the present invention comprises: a rotatable mirror for reflecting light; a pair of springs for supporting the mirror, the springs serving as a rotary axis for the mirror when the mirror is rotationally driven; a connection member for connecting the mirror and the pair of springs; and a frame provided with electrodes for generating electrostatic force to rotate the mirror.

The window lid may be horizontal in relation to the substrate at its top surface except the light transmitting part. The window lid may be formed from a transparent material which can transmit light.

The light transmitting part may have a slope angle in relation to the micro-mirror device, which is larger than the scan angle of the mirror and may have any geometric shape in cross-section. For example, the light transmitting part may have a parallelogram shape, a trapezoid shape, a "Z" shape, or a lens shape in cross-section. The light transmitting part may have a slope angle in relation to the micro-mirror device, which is larger than the scan angle of the mirror.

The supporting parts may have a height sufficient to secure a space for allowing the mirror to rotate in the substrate. In addition, the supporting parts may have a top surface which is horizontal in relation to the substrate. With this configuration, the micro-mirror package can be fabricated through a batch process.

According to another exemplary embodiment of the present invention, there is provided a method of fabricating a micro-mirror device package comprising providing a wafer formed with an array of micro-mirror devices; bonding the wafer to a substrate; fabricating an array of window lids, each having a light transmitting part, which is sloped in relation to the micro-mirror device, and through which laser beams are transmitted to a corresponding micro-mirror device, and supporting parts downwardly extending from the light transmitting part; adhering the window lid array on the surface of the wafer; and singulating the wafer into individual unit micro-mirror devices.

The singulation of the wafer lid array may be performed along the top surfaces of the respective supporting parts.

### BRIEF DESCRIPTION OF THE DRAWINGS

The above aspects of the present invention will be more apparent from the description of exemplary embodiments of the present invention, taken with reference to the accompanying drawings, in which:

FIG. 1 is a cross-sectional front view of a conventional micro-mirror device;

FIG. 2 is an exploded perspective view of the conventional micro-mirror device;

FIG. 3 is a view for describing a course of a beam progressing forward in the micro-mirror device package of FIG. 1;

FIG. 4 is a cross-sectional view of a sloped package of another conventional micro-mirror device;

FIGS. 5 to 8 are cross-sectional views of micro-device packages according to various exemplary embodiments of the present invention;

FIG. 9 is a view showing an operating state of a package according to an exemplary embodiment of the present invention;

FIGS. 10A to 10C are cross-sectional views of a package according to an exemplary embodiment of the present invention for describing the process of fabricating the package;

FIG. 11 is a top plan view of a wafer formed with micro-mirror devices in the process of fabricating a package according to an exemplary embodiment of the present invention; and

FIGS. 12 to 14 are cross-sectional views of a package according to another exemplary embodiment of the present invention for describing the process of fabricating the package.

### DETAILED DESCRIPTION OF EXEMPLARY EMBODIMENTS

Hereinbelow, embodiments of the present invention are described in detail with reference to accompanying drawings.

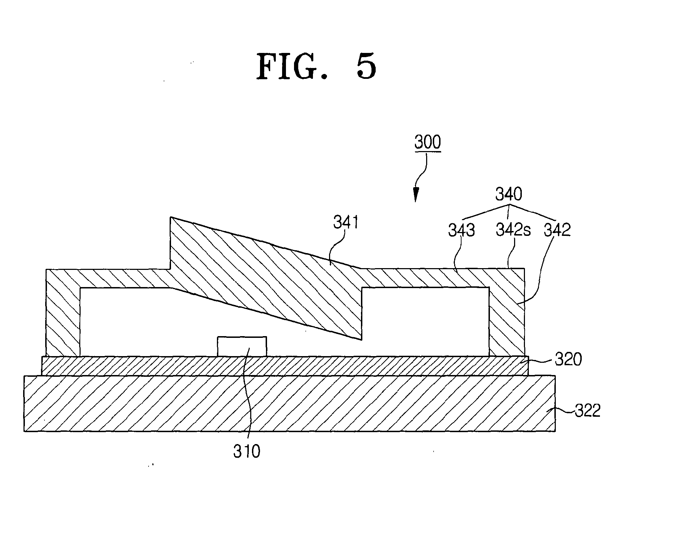

FIG. 5 to FIG. 8 exemplify various structures of micro-mirror packages according to various exemplary embodiments of the present invention. The micro-mirror device package 300 of FIG. 5 includes a micro-mirror device 310, a substrate 320, on which the micro-mirror device 310 is mounted, and a window lid 340 mounted on the substrate 320 to cover the micro-mirror device 310.

Any of well-known micro-mirror devices may be applicable as the micro-mirror device 310. For example, a micro-mirror device suitable for the present invention may be the micro-mirror device 110, as shown in FIGS. 1 and 2, which comprises: a rotatable mirror 111 for reflecting light; a pair of springs 113 for supporting the mirror, the springs 113 serving as a rotary axis of the mirror when the mirror is rotationally driven; a connection member 112 for connecting the mirror 111 and the springs 113; and frame 114 having electrodes for generating electrostatic force so that the mirror 111 rotates.

Although the mirror 111 shown in FIG. 2 has a circular shape, the mirror 111 of the present invention is not limited to this shape and the mirror 111 may be provided to have a minimum area required for reflecting light. The connection member 112 may have an oval shape, for example. Numerous movable combs (not shown) are located along the rim of the connection member 112, so that an electrostatic force acts between the movable combs and stationary combs (not shown) provided on the frame 114, thereby rotating the mirror 111 about the springs 113. The frame 114 includes electrodes 115, through which current is applied to the movable combs and the stationary combs. The micro-mirror device having this construction is described in detail in Korean unexamined patent publication No. 10-2005-0053053.

The micro-mirror device 310 is mounted on the substrate 320. If desired, it is possible to provide another substrate, such as a ceramic substrate 322, in addition to the substrate 320.

According to an exemplary embodiment of the present invention, the window lid 340 includes a light transmitting part 341, and supporting parts 342 for supporting the light transmitting part 341. The window lid 340 may be formed from a transparent material, e.g., glass or transparent plastic, or the like.

The light transmitting part 341 is sloped in relation to the micro-mirror device 310, more specifically, in relation to the mirror of the device, and the supporting parts 342 are downwardly extended from the light transmitting part 341. It is possible to design the window lid 340 in such a way that its top surface 343, except for the light transmitting part 341, is horizontal in relation to the substrate 320. That is, because the window lid 340 of the present embodiment is formed in such a way that at least a part of the top surface 343 is horizontal, wafer level packaging is allowed when the package is fabricated and the package can be easily seated on a substrate, as will be described later.

According to the present exemplary embodiment, the part beyond the light transmitting part 341 of the window of the package may be formed from a light transmitting material. However, it is beneficial for the light transmitting part to have a predetermined slope angle. That is, the light transmitting part 341 has a slope angle in relation to the micro-mirror device 310, which is larger than the scan angle of the mirror. The slope angle of the light transmitting part 341 is determined depending on the scan angle in a micro-scanner having such a micro-mirror device. For example, if the rotating angle of the mirror is ±8 degrees, it is sufficient that the slope angle of the light transmitting part 341 is larger than 8 degrees. In that event, because beams reflected from the surface of the window lid 340 can progress forward in a different direction or in a different range of angle as compared to an image beam projected by the scan of the mirror, noise beams do not arrive at the screen.

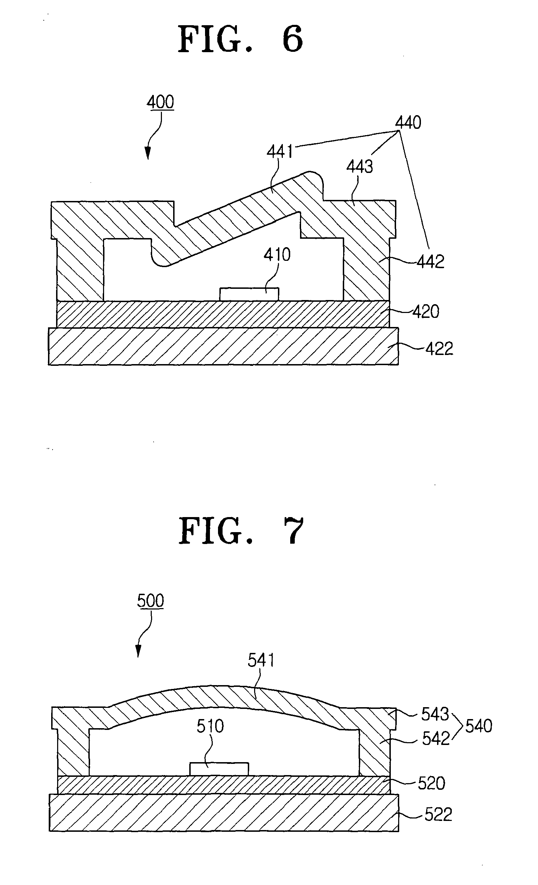

The light transmitting part 341 may have any geometric shape in cross-section. In the case of the package 300 shown in FIG. 5, although the light transmitting part has a parallelogram shape in cross-section, the package 300 may have various shapes as shown in FIGS. 6 to 8. For example, in the case of the package 400 shown in FIG. 6, the light transmitting part 441 has a "Z" shape in cross-section. A substrate 420 is provided, on which the micro-mirror device 410 is mounted. A window lid 440 is mounted on the substrate 420 to cover the micro-mirror device 410. The light transmitting part 441 is supported by supporting parts 442 of the window lid 440. It is possible to design the window lid 440 in such a way that its top surface 443, except for the light transmitting part 441, is horizontal in relation to the substrate 420. The light transmitting part 441 is sloped in relation to the micro-mirror device 410, more specifically, in relation to the mirror of the micro-mirror device 410, and the supporting parts 442 are downwardly extended from the light transmitting part 441. Another substrate, such as a ceramic substrate 422, may be used with the substrate 420.

In the case of package 500 shown in FIG. 7, the light transmitting part 541 has a lens shape in cross-section. A substrate 520 is provided, on which the micro-mirror device 510 is mounted. A window lid 540 is mounted on the substrate 520 to cover the micro-mirror device 510. The light transmitting part 541 is supported by supporting parts 542 of the window lid 540. Another substrate, such as a ceramic substrate 522, may be used with the substrate 520. It is possible to design the window lid 540 in such a way that its top surface 543, except for the light transmitting part 541, is horizontal in relation to the substrate 520. The light transmitting part 541 is sloped in relation to the micro-mirror device 510, more specifically, in relation to the mirror of the device, and the supporting parts 542 are downwardly extended from the light transmitting part 541.

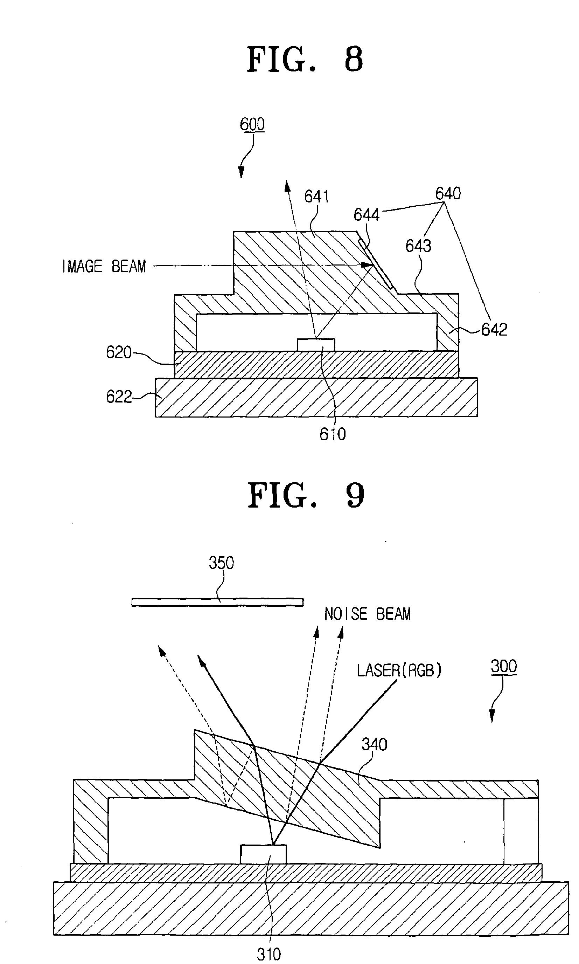

In the case of the package 600 shown in FIG. 8, the light transmitting part 641 has a trapezoid shape in cross-section. A substrate 620 is provided, on which the micro-mirror device 610 is mounted. A window lid 640 is mounted on the substrate 620 to cover the micro-mirror device 610. The light transmitting part 641 is supported by supporting parts 642 of the window lid 640. Another substrate, such as a ceramic substrate 622, may be used with the substrate 620. It is possible to design the window lid 640 in such a way that its top surface 643 is horizontal in relation to the substrate 620.

The light transmitting parts are sloped to have a slope angle in relation to a corresponding micro-mirror device, which is larger than the scan angle of a corresponding mirror.

Reference numerals indicating parts of the packages in FIGS. 6 and 8 are similar to those used for indicating the corresponding parts of the package in FIG. 5. However, in the package 600 of FIG. 8, the light transmitting part 641 has a trapezoid shape (or a prismatic shape), and a reflecting surface 644 is provided on a sloped surface because image beams enter from a lateral side of the light transmitting part 641.

Unlike the existing micro-mirror device packages 100 and 200, the package 300 according to an exemplary embodiment of the present invention is provided with supporting parts 342 on the window lid 340. According to this embodiment, the supporting parts 342 of the window lid 340 have a height sufficient to secure a space allowing the mirror of the micro-mirror device 310 to rotate, and surround the device 310. The space may be in a vacuum state. Because the supporting parts 342 may form a horizontal surface in relation to the substrate 320, the package according to this embodiment can be fabricated in a wafer level size through a batch process, as will be described later.

FIG. 9 shows a course of an image beam progressing through the micro-mirror device package 300. The package 300 provides a relatively superior image quality because the courses of the noise beams generated from the surface of the window lid 340 and the course of a scanned beam are separated from each other and the noise beams do not arrive at the screen 350, as shown in FIG. 9.

Exemplary embodiments of the present invention improve packaging technology for micro-mirror devices, thereby making it possible to further miniaturize a micro-mirror package as compared to existing micro-mirror packages. For example, although the height of the short side of the housing or insulation structure 230 of FIG. 4 is about 3.0 mm and the height of the long side is about 7.5 mm, which is representative of existing sloped packages, the package 300 can have a height in a range of 1 to 2 mm, for example, which is slightly larger than the thickness of the micro-mirror device; as a result, the entire size of the package can be greatly reduced. In addition, according to the fabrication method described below, it is possible to fabricate packages configured as described above in large quantities.

Exemplary methods of fabricating a micro-mirror device package according to embodiments of the present invention are described in detail with reference to the accompanying drawings.

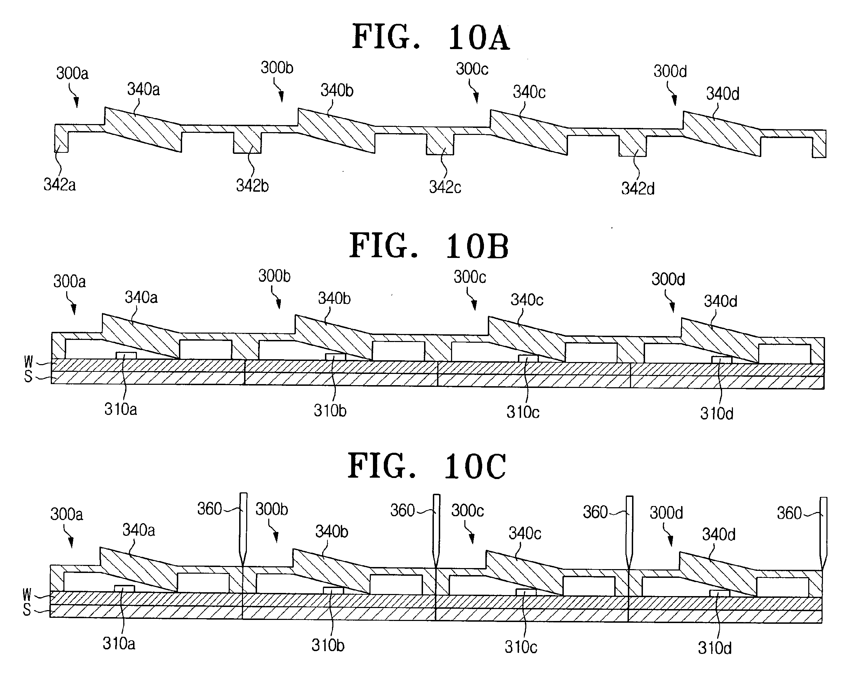

FIGS. 10A to 10C show a method of fabricating the package of FIG. 5. Referring to the drawings, a wafer W formed with an array of micro-mirror devices 310a, 310b, 310c, 310d, ... is prepared at first (see FIG. 10B). Such a wafer W can be fabricated using conventional MEMS fabrication technology.

Then, the wafer W is bonded to the top side of a substrate S using a semiconductor bonding technology (see FIG. 10B).

Then, an array of window lids 340a, 340b, 340c, 340d, ... for covering the wafer are fabricated. The window lid array 340a, 340b, 340c, 340d, ... can be fabricated specifically using a cast in a wafer size to correspond to the array of individual devices 310a, 310b, 310c, 310d, ... formed on the wafer W. The window lid array is formed with light transmitting parts 341a, 341b, 341c, 341d, ..., which are sloped to respectively correspond with the individual micro-mirror devices 310a, 310b, 310c, 310d, ... formed on the wafer, and plural supporting parts 342a, 342b, 342c, 342d, ... are formed downwardly from the individual light transmitting parts (see FIG. 10A).

Because the window lid array is sloped on predetermined areas of the top side thereof and the areas around the individual supporting parts are horizontal, it is possible to fix the window lid array on the wafer W. Due to the structure of the window lid array, and more precisely due to the structure of the individual window lids 340a, 340b, 340c, 340d..., the micro-mirror device can be fabricated in a wafer level size.

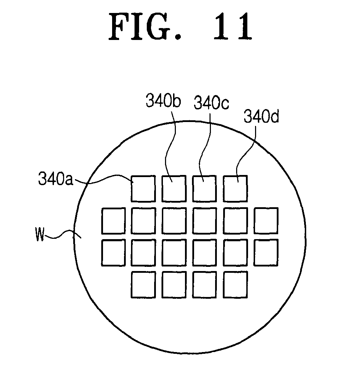

Thereafter, the fabricated window lid array is adhered to the surface of the wafer by sealing as shown in FIG. 10B, and the wafer W is singulated into individual unit micro-mirror devices by a cutter 360 as shown in FIG. 10C. FIG. 11 is a top plan view of the wafer W, in which the singulation can be performed along the areas between adjacent window lids, in other words along the top surfaces 342s ,as shown in FIG. 5, of the individual supporting parts 342a, 342b, 342c, 342d... Therefore, each device may be formed in the shape shown in FIG. 5.

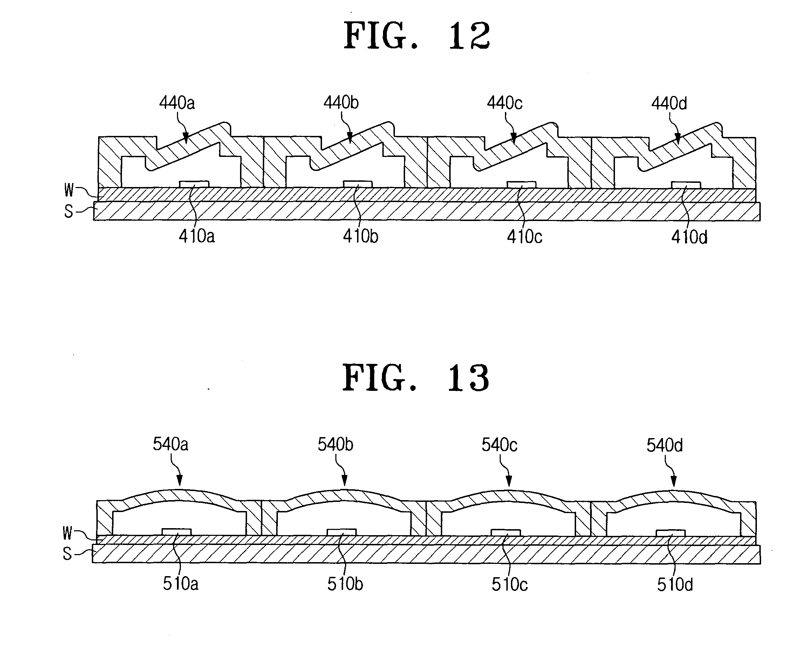

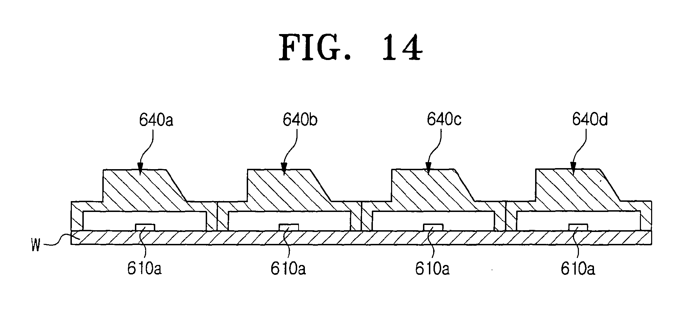

FIGS. 12 to 14 show arrays of packages according to other exemplary embodiments of the present invention, which are provided with arrays of window lids of a "Z" shape, a lens shape and a trapezoid shape, respectively. Because the constructions shown in FIGS. 12 to 14 are substantially same with those described with reference to FIGS. 6 to 8, detailed description thereof is omitted.

As described above, the micro-mirror device packages have a window lid improved in structure, whereby an image beam and noise beams induced from the image beam can be easily separated.

In addition, the micro-mirror device packages can be greatly reduced in size by removing a housing or an insulation structure, unlike existing packages, thereby enabling the miniaturization of a package.

Furthermore, according to the exemplary methods of fabricating a micro-mirror device package, the micro-mirror device package can be fabricated through a batch process performed in terms of a wafer size. This fabrication method is simple and very suitable for mass production, thereby reducing the cost of packages.

Although representative exemplary embodiments of the present invention have been shown and described in order to exemplify the principle of the present invention, the present invention is not limited to the specific embodiments. It will be understood that various modifications and changes can be made by one skilled in the art without departing from the spirit and scope of the invention as defined by the appended claims. Therefore, it shall be considered that such modifications, changes and equivalents thereof are all included within the scope of the present invention.

## Claims

1. A micro-mirror device package comprising:
a micro-mirror device;
a substrate, on which the micro-mirror device is mounted; and
a window lid mounted on the substrate to cover the micro-mirror device, wherein the window lid has a light transmitting part, which is sloped in relation to the micro-mirror device, and through which laser beams are transmitted to the micro-mirror device, the window lid comprising support parts which extend downwardly from the light transmitting part.

2. A micro-mirror device package as claimed in claim 1, wherein the micro-mirror device comprises:
a rotatable mirror which reflects light;
a pair of springs which supports the mirror, the springs serving as a rotary axis for the mirror when the mirror is rotationally driven;
a connection member which connects the mirror and the pair of springs; and
a frame provided with electrodes which generates electrostatic force to rotate the mirror.

3. A micro-mirror device package as claimed in claim 1, wherein the window lid is horizontal, in relation to the substrate at its top side, except for the light transmitting part.

4. A micro-mirror device package as claimed in claim 1, wherein the window lid is formed from a transparent material which can transmit light.

5. A micro-mirror device package as claimed in claim 1, wherein the light transmitting part has a slope angle in relation to the micro-mirror device, which is larger than a scan angle of a mirror of the micro-mirror device.

6. A micro-mirror device package as claimed in claim 1, wherein the light transmitting part has a predetermined geometric shape in cross-section.

7. A micro-mirror device package as claimed in claim 6, wherein the predetermined geometric shape has a parallelogram shape in cross-section.

8. A micro-mirror device package as claimed in claim 6, wherein the predetermined geometric shape has a "Z" shape in cross-section.

9. A micro-mirror device package as claimed in claim 6, wherein the predetermined geometric shape has a lens shape in cross-section.

10. A micro-mirror device package as claimed in claim 6, wherein the predetermined geometric shape has a trapezoid shape in cross-section.

11. A micro-mirror device package as claimed in claim 1, wherein the support parts have a height sufficient to secure a space which allows a mirror of the micro-mirror device to rotate in the substrate.

12. A micro-mirror device package as claimed in claim 1, wherein the support parts have a top surface which is horizontal in relation to the substrate.

13. A method of fabricating a micro-mirror device package comprising:
providing a wafer formed with an array of micro-mirror devices;
bonding the wafer to a substrate;
fabricating an array of window lids, each having a light transmitting part, which is sloped in relation to the micro-mirror devices, respectively, and through which laser beams are transmitted to a corresponding micro-mirror device, and supporting parts downwardly extending from the light transmitting part;
adhering the array of window lids to a surface of the wafer; and
singulating the wafer into individual micro-mirror device units.

14. A method as claimed in claim 13, wherein the array of window lids is formed in such a way that a top side of the array of window lids, except for the light transmitting parts, are horizontal in relation to the substrate.

15. A method as claimed in claim 13, wherein the array of window lids is formed from a transparent material which can transmit light.

16. A method as claimed in claim 13, wherein the array of window lids is fabricated in such a way that each light transmitting part has a slope angle in relation to a corresponding micro-mirror device, which is larger than a scan angle of a corresponding mirror of the micro-mirror devices.

17. A method as claimed in claim 13, wherein the array of window lids is fabricated in such a way that the light transmitting parts have a predetermined geometric shape in cross-section.

18. A method as claimed in claim 17, wherein the array of window lids is fabricated in such a way that the predetermined geometric shape has a parallelogram shape in cross-section.

19. A method as claimed in claim 17, wherein the array of window lids is fabricated in such a way that the predetermined geometric shape has a "Z" shape in cross-section.

20. A method as claimed in claim 17, wherein the array of window lids is fabricated in such a way that the predetermined geometric shape has a lens shape in cross-section.

21. A method as claimed in claim 17, wherein the array of window lids is fabricated in such a way that the predetermined geometric shape has a trapezoid shape in cross-section.

22. A method as claimed in claim 13, wherein the array of window lids is fabricated in such a way that the supporting parts have a height sufficient to provide spaces each for allowing a corresponding mirror to rotate in the substrate.

23. A method as claimed in claim 13, wherein the array of window lids is fabricated in such a way that the supporting parts have top surfaces, respectively, which are horizontal in relation to the substrate.

24. A method as claimed in claim 13, wherein the singulation of the wafer is performed along top surfaces of the respective supporting parts.
